Europäisches Patentamt

European Patent Office

Office européen des brevets

(11) Publication number: **0 169 561**
**A2**

## (12) EUROPEAN PATENT APPLICATION

(21) Application number: **85109324.5**

(22) Date of filing: **25.07.85**

(51) Int. Cl.⁴: **H 01 J 37/317**
**H 01 J 37/304, G 03 F 7/20**

(30) Priority: **26.07.84 US 634715**

(43) Date of publication of application:
**29.01.86 Bulletin 86/5**

(84) Designated Contracting States:
**DE GB NL**

(71) Applicant: **THE PERKIN-ELMER CORPORATION**
**761 Main Avenue**
**Norwalk Connecticut 06859(US)**

(72) Inventor: **Carroll, Allen**
**1725 Shattuck Avenue**
**Berkeley California 94709(US)**

(72) Inventor: **Cavan, Daniel L.**
**7 Orchard Hill Road**
**Woodside California 94062(US)**

(74) Representative: **Patentanwälte Grünecker, Kinkeldey,**
**Stockmair & Partner**
**Maximilianstrasse 58**
**D-8000 München 22(DE)**

(54) **Control strategy for microlithography instrument.**

(57) Disclosed is a microlithography instrument which employs a vector-scan strategy with a movable substrate stage whose position is continuously monitored, an electron beam source for exposing a substrate on said stage by beam deflection technology, with means for storing pattern data to be exposed on said substrate, methods for sorting said data into groups or frames with pattern placement coordinates referenced to corresponding frame centers, and means for monitoring the position of said stage as the latter continuously moves so that the beam accurately tracks the moving substrate while the beam is deflected to define the pattern in each frame. The coordination of stage motion and beam deflection enables the instrument to vector-scan as the substrate moves allowing full speed potential of vector-scan strategy to be realized.

./...

FIG. 9

-1-

CONTROL STRATEGY FOR MICROLITHOGRAPHY
INSTRUMENT

BACKGROUND OF THE INVENTION

This invention relates to scanning-beam microlithography instruments and is particularly directed to an improvement in microlithography instruments emplòying the vector-scan beam deflection strategy as distinguished from those instruments which employ raster scan beam deflection strategy.

Previous scanning beam microlithography instruments employing a vector-scan beam deflection strategy sacrifice some of their potential speed due to an inefficient, step-and-write pattern of moving the substrate stage under the scanned beam. In those instruments pattern exposure is stopped during stage motion and resumed after the stage was again still. The step-and-write pattern also introduced unwanted vibration in these instruments. Some raster-scan microlithography instruments have avoided this stage movement penalty by moving the stage at a nearly constant velocity under the scanned beam. Raster-scan systems, however, suffer from other inefficiencies, including the necessity to address non-exposed areas on the substrate and the coupling of pattern placement resolution to a minimum feature size. Such a raster-scan system with a continuously moving stage and pattern placement to a minimum feature size is disclosed in the U. S. Patent to Collier et al No. 3,983,401.

This invention overcomes the problems of the prior art by providing a means of coordinating the stage motion to vector-scan beam deflection so that the substrate stage can move smoothly and continuously. It enables the instrument to continue vector scanning as the substrate moves and allows the full speed potential of the vector-scan strategy to be realized.

Stated another way, the so-called "write-on-the-fly" systems in which there is coordination between stage motion and beam deflection is practiced in the prior art only in instruments which employ a raster-scan beam deflection strategy. This invention is the first to practice "write-on-the-fly" technique in an instrument which uses vector-scan strategy, and its implementation is quite different from that employed in the prior art instruments, as will be apparent to those skilled in the art from the following Detailed Description and accompanying Drawings.

## SUMMARY OF THE INVENTION

In a microlithography instrument which employs a vector-scan strategy with a movable substrate stage, an electron beam source for exposing a substrate on said stage by beam deflection technology, and means for storing pattern data to be exposed on said substrate, the improvement comprising, methods for sorting said data into groups or frames with pattern placement coordinates referenced to corresponding frame centers, means for monitoring the position of said stage as the latter continuously moves so that the beam deflection is the sum of a vector updated in real time directed towards the frame centers with fixed vectors representing the placement of pattern features relative to the frame centers.

## BRIEF DESCRIPTION OF THE DRAWINGS

Figure 1 illustrates a chip with pattern figures and placement vectors as initially referenced from a point of origin for CAD data and non-overlapping frames located side-by-side,

Figure 2 is an enlargement of a portion of the pattern figures of Figure 1 to illustrate a typical pattern on the chip,

Figure 3 illustrates a typical prior art arrangement of pattern figures sorted into groups or frames with the pattern figures and figure placement vectors referenced to the frame centers of non-overlapping frames,

Figure 4 illustrates the frames overlapping with the frames centers and figure placement vectors sorted in accordance with this invention,

Figure 5 is an enlargement of the pattern figures of Figure 4 to illustrate the placement vectors referenced to the centers of the overlapping frames,

Figure 6 illustrates a figure placement vector referenced to a frame center with an additional deflection to compensate for continuous stage movement,

Figure 7 illustrates the size relationship of the frame error correction windows relative to the frame,

Figure 8 is an enlargement of Figure 7 to illustrate the stage path near frame centers with frame error correction windows overlapped for frame error correction, and

Figure 9 is a simplified schematic illustration of the electron beam microlithography instrument to perform the pattern figure writing in accordance with this invention.

DETAILED DESCRIPTION OF THE INVENTION

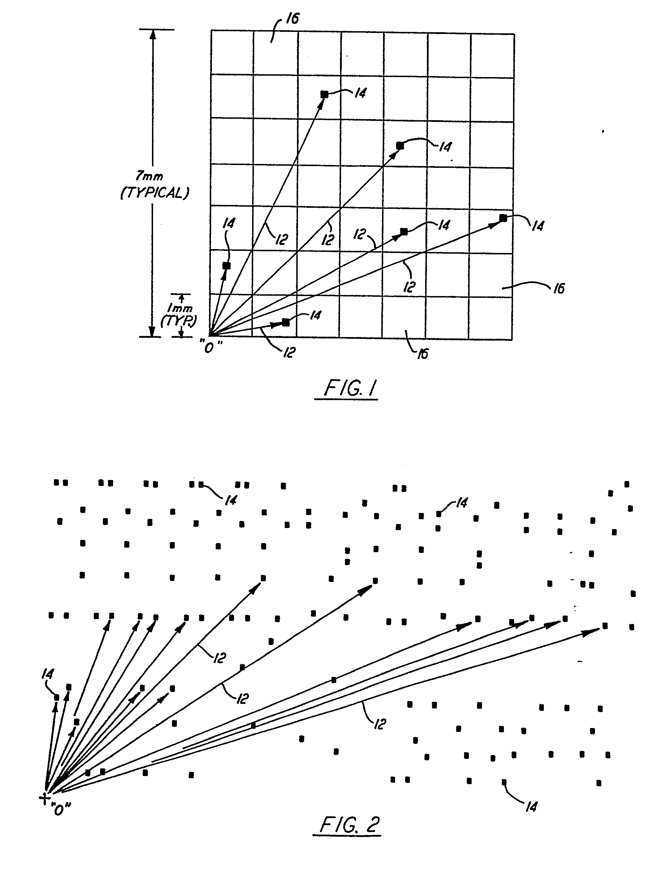

Turning first to Figures 1 and 2 there is illustrated a chip 10 of a substrate on which pattern data is to be exposed. The pattern data is referenced by vectors 12 to a single point of origin "0" with the square dots 14 representing the spots (figure geometries) to be exposed (delineated) by an electron beam. Only a few of the figure geometries are shown for clarity and are shown square in cross-section in this illustration. This is a typical pattern of placement coordinates of geometries to be delineated by the microlithography instrument and is usually generated by computer aided design techniques (CAD) when designing the desired chip configurations. Figure 1, while only showing a few of the figure geometries of Figure 2, does show the chip divided into "frames" 16 sometimes called "beam deflection fields" or "optical fields". The size of the frames correspond to the maximum deflection of the beam.

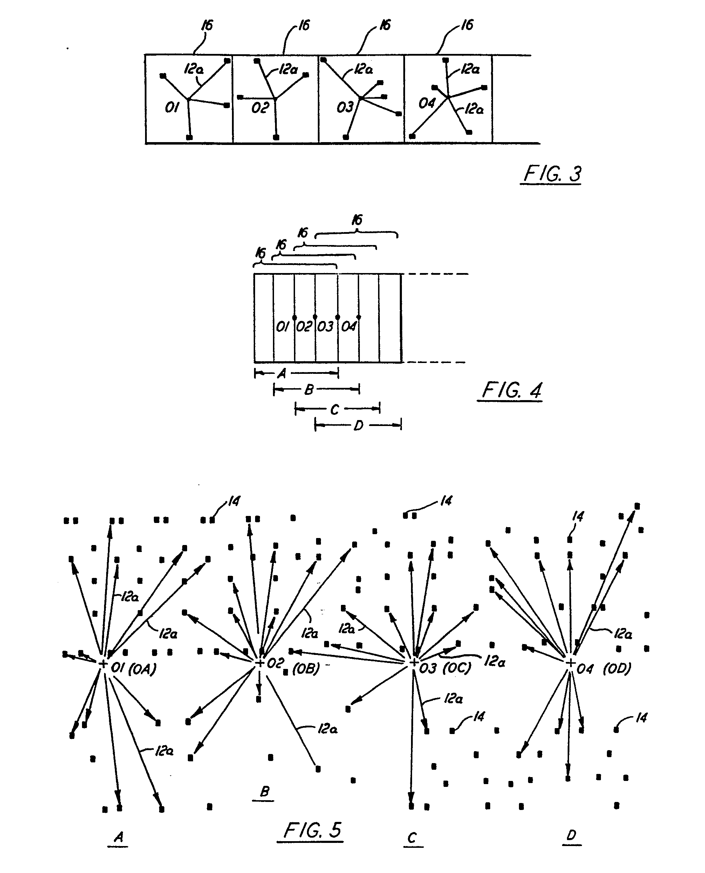

Figure 3 illustrates more clearly the geometries 14 to be delineated except that the pattern data has been sorted into the frames (four being shown) and the geometry placement coordinates, (vectors 12a), are altered to refer to corresponding frame centers 01, 02, 03, etc.

Figures 1-3 are similar to the practice employed in the prior art of "step-and-write" stage motion as employed in previous vector-scan instruments. The prior art uses a rigid rule for sorting figures into frames, while this invention sorts figures so as to make the exposure times of the various frames nearly equal to one another. This is represented in Figure 4 which shows the frames (now identified as Frames A, B, C and D) overlapped and the frame centers closer together.

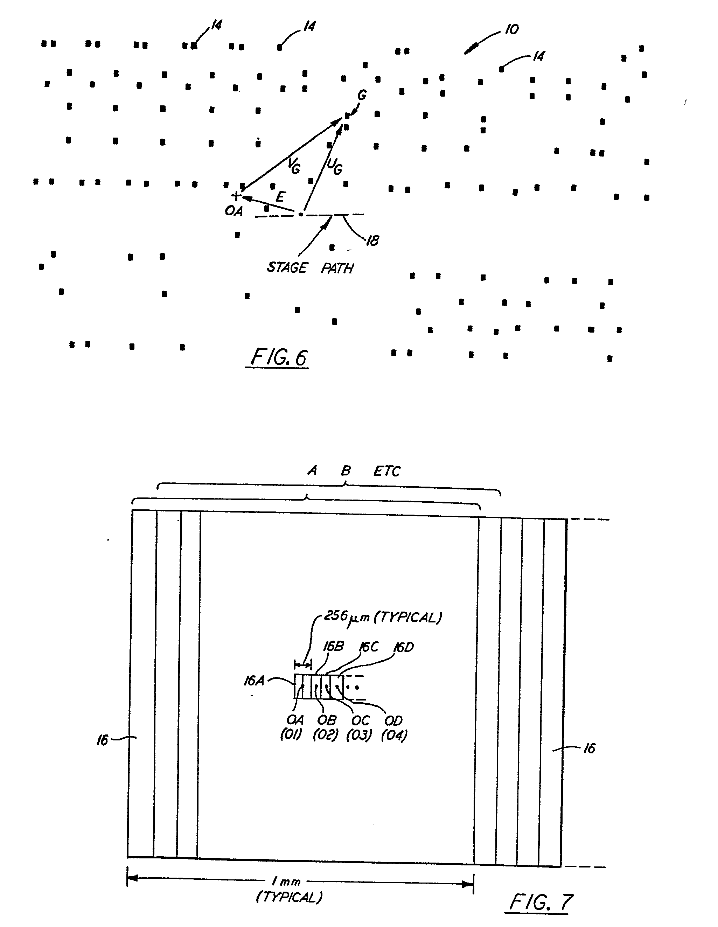

Figure 5 is an enlargement of Figure 4 illustrating the corresponding frame center points 01, 02, 03 and 04 etc. but shows more clearly how the vectors may overlap for the purpose of making the exposure times of the various frames nearly equal to one another. The frame centers are now identified as OA, OB, OC and OD to corresond to the frame identification A, B, C and D.

Figure 6 illustrates the same pattern data with the beam deflection for geometry G compensated for stage travel illustrated by the dotted line 18. In this figure, placement vector VG of geometry G is referred to the frame center OA and the frame error vector E is added to vector G to give a net deflection vector UG. How and why this is accomplished will be clear from the more detailed description hereinafter.

Figure 7 shows the relationship between the frame error correction windows 16A - 16D and the frames. The frame error correction windows are smaller than the frames due to the high data rate required to track the stage accurately.

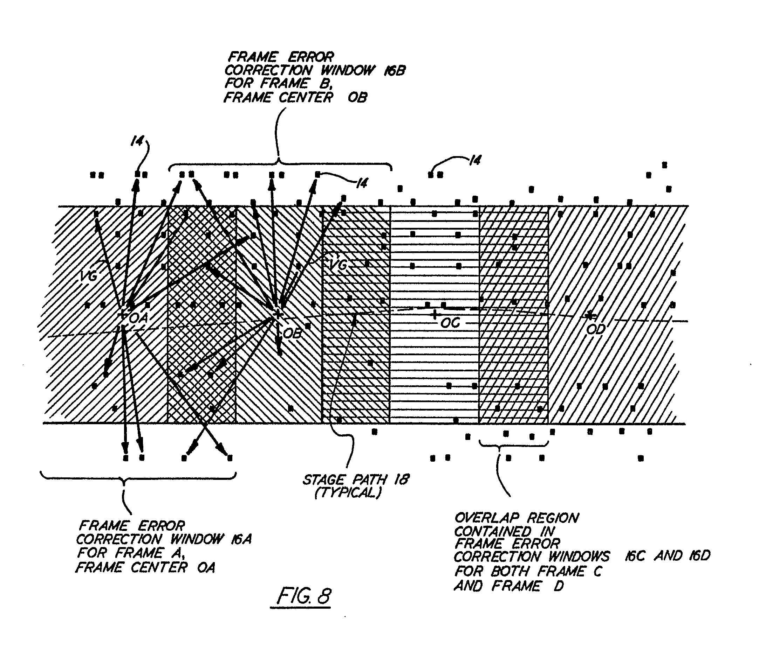

Figure 8 illustrates the stage path 18 (neutral position of the beam) passing near frame centers OA, OB, OC, OD, etc. in sequence illustrating the deflection of the beam (vector VG) for the figure geometries, with overlapping frame error windows 16A - 16D for the respective frames A, B, C, and D. In this illustration, adjacent frame error correction windows overlap one another. The stage, while continuously moving near the frame centers, will adjust its velocity so as to remain in each frame error correction window for as long as it takes to write the data in that frame. The density of the data will determine the velocity of the stage and the figure sorting method previously described ensures that the modulation of stage velocity is gentle enough to prevent excessive mechanical disturbance.

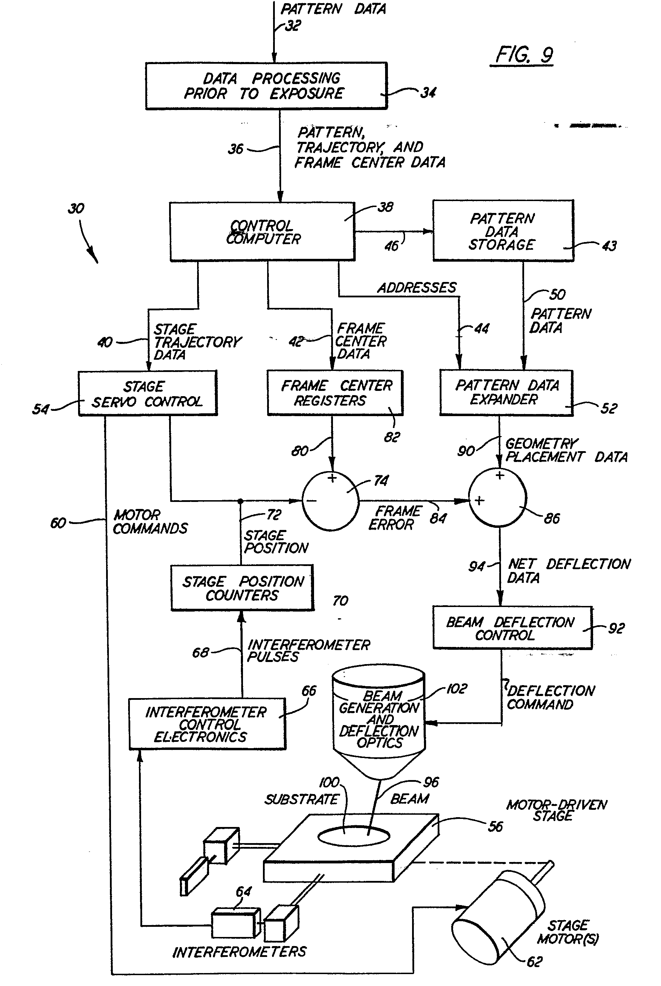

Turning now to Figure 9, pattern data, representing the placement coordinates of geometries to be delineated by the microlithography instrument, as illustrated in Figure 1 and initially referenced to a single point of origin, is entered into the instrument 30 via data communication means 32 and is processed and sorted at stage 34 into frames and the original geometry placement vectors are then referred to corresponding frame centers. See Figure 5. Thereafter, the pattern, trajectory and frame center data, sorted at 34, are entered via data communication line 36 into the control computer 38. Control computer 38 divides the data into three paths--stage trajectory data path 40, frame center data path 42, and address path 44.

The control computer 38 also directs pattern data along path 46 to the pattern data storage stage 48, which in turn, is connected via data path 50 to a pattern expander 52. The control computer also times the operation of the microlithography instrument. A stage servocontrol system 54, responsive to the stage trajectory data, continually monitors and commands the movement of motor driven stage 56 via motor command line 60 connected to stage drive motors 62. The position of the stage is continually monitored by interferometers 64 and their associated interferometer control electronics 66. The output pulses from the interferometer control electronics 66 are directed via line 68 to stage position counters 70. The output from the stage position counter 70 is connected by stage position data line 72 to the stage servocontrol 54 and to adder 74. Adder 74 also receives frame center data via data path 80 from frame center registers 82, where frame center data entered from the frame center path 42 is stored.

Thus, a digital representation of the stage positon vector is subtracted from the contents of the frame center registers 82 and the vector result of that subtraction is called "frame error" E (see Figure 6). This error E is continually updated as the stage moves. Frame error E is entered into frame error line 84 which, in turn, is connected to adder 86. Geometry placement data entered on data line 90 from the pattern data expander, which includes the addresses for the pattern data, is a placement vector, such as VG, of a particular geometry referenced to a frame center such as OA, in the pattern data as shown in Figure 6. By adding a placement vector VG to the frame error E, a continuously updated quantity is obtained which represents a vector, such as UG, from the neutral position of the beam to the desired location of the geometric figure on the substrate. Signals representing the resulting vector UG are deflection commands which are applied to the beam deflection control stage 92 via the output net deflection line 94 to move the landing point of the beam 96 on substrate 100 to the desired site of geometry G. Thus, the stage can be permitted to move about and the beam will remain stably positioned at the desired site of geometry G. Beam column 102 contains suitable beam generation and deflection optic means.

In practice, feasible beam deflections are quite small (less than a few millimeters) due to the accuracy and resolution limitations of scanning beam optics. This limitation is overcome by having the stage 56 move smoothly along a trajectory devised such that the neutral position of the beam will pass near each frame center in an appropriate sequence. (See Figure 8). As the stage moves to bring frame center OA, for example, near to the neutral position of the beam, data representing the coordinates of OA are loaded into the frame center registers 82. Then, any geometries whose positions are referred to the coordinates of OA may be written. As the stage moves to bring the center OB near the neutral position of the beam, and after all the geometries referred to OA have been written, then the coordinates of OB are loaded into the frame center registers 82 and all the geometries whose positions are referred to OB are written, etc.

Using exposure duration information derived from the pattern data, the stage trajectory is computed prior to the exposure. This stage trajectory includes a complete description of the stage position, speeds and times. The stage trajectory data is computed so that the neutral position of the beam will pass within a rather small distance (typically less than 200 micrometers) of each frame center and will remain within that range for as long as it takes to expose all data referred to that frame center, that is, all geometries within that frame. These small distances are within the frame error correction windows previously described. The frame center locations are chosen so that successive frame error correction windows overlap, as described above, thus enabling almost continuous exposure of pattern geometries.

What is claimed is:

1. In an electron beam exposure instrument employing a vector-scan technique and wherein a beam is directed to a substrate to be exposed,

means for generating said beam,

deflection optics for deflecting said beam from a neutral position to a deflected position,

means for modulating said beam to expose said substrate at points on the substrate according to predetermined pattern from data received by said instrument,

means for moving said substrate continuously as said substrate is exposed to said beam,

means for monitoring the position of said substrate,

means for determining the difference between the position of said substrate and a reference position called a 'frame center',

means for updating frame center data from time to time, and

means for compensating for the difference between the position of said substrate and the frame center so that said deflected beam will be positioned at the required point as said deflection optics and modulation means are activated.

2. An electron beam exposure instrument wherein a beam is radiated to a medium placed on a continuously moving stage comprising,

means for providing position data of said continuously moving stage,

means for providing deflection data and exposure data for said beam, including center points defined on said medium and data for the deflection of said beam radially from said center points and exposure of said medium,

means for storing and processing position data of said continuously moving stage,

means for storing and processing deflection data for said beam,

means for utilizing said position data for moving said stage along a path so that the neutral position of said beam passes sequentially near selected frame center points,

means for obtaining the difference between the actual position of beam in its neutral positions and the frame center points as the stage continuously moves, and

means for correcting said deflection data in accordance with the position of said stage and position of said frame center point so that said beam will expose said medium in accordance with said exposure data.

3.    An electron beam lithography system utilizing the vector scan technique and having a continuously moving stage and means for directing an electron beam towards a mask or wafer mounted on said continuously moving stage,

means for generating signals for continuously monitoring the position of said stage,

means for storing and generating signals representing the pattern data to be delineated on said mask or wafer, and

means for continuously moving said stage in a path so that neutral position of said beam passes through or near said center points.

4.  In a particle beam lithography system capable of utilizing a vector-scan technique for exposing a medium located on a stage with predetermined pattern of figure geometries and having means for receiving and storing pattern data from an outside source the method of,

processing said data to define side-by-side frames of data on said medium by which the particle beam will expose figure geometries located with respect to central points of said frames,

overlapping said frames to bring said center points closer together on said medium,

continuously moving the stage in a path so that the neutral position of said beam passes sequentially through or near said center points,

continuously monitoring the position of said stage relative to the neutral position of said particle beam and the center points, and

processing the deflection data so that the figure geometries will be delineated according to the predetermined pattern.

115

FIG. 1

FIG. 2

215

_FIG. 3_

_FIG. 4_

_FIG. 5_

FIG. 6

FIG. 7

FRAME ERROR
CORRECTION WINDOW 16B
FOR FRAME B,
FRAME CENTER OB

FRAME ERROR
CORRECTION WINDOW 16A
FOR FRAME A,
FRAME CENTER OA

STAGE PATH 18
(TYPICAL)

OVERLAP REGION
CONTAINED IN
FRAME ERROR
CORRECTION WINDOWS 16C AND 16D
FOR BOTH FRAME C
AND FRAME D

FIG. 8

5/5

PATTERN DATA
32

FIG. 9

DATA PROCESSING PRIOR TO EXPOSURE — 34

PATTERN, TRAJECTORY, AND FRAME CENTER DATA — 36

30

CONTROL COMPUTER — 38

PATTERN DATA STORAGE — 43

46

ADDRESSES

50 PATTERN DATA

40 STAGE TRAJECTORY DATA

42 FRAME CENTER DATA

44

STAGE SERVO CONTROL — 54

FRAME CENTER REGISTERS — 82

PATTERN DATA EXPANDER — 52

80

90 GEOMETRY PLACEMENT DATA

74 +/−

86 +/+

60 MOTOR COMMANDS

72 STAGE POSITION

FRAME ERROR 84

94 NET DEFLECTION DATA

STAGE POSITION COUNTERS — 70

BEAM DEFLECTION CONTROL — 92

68 INTERFEROMETER PULSES

BEAM GENERATION AND DEFLECTION OPTICS — 102

DEFLECTION COMMAND

66 INTERFEROMETER CONTROL ELECTRONICS

100 SUBSTRATE

96 BEAM

MOTOR-DRIVEN STAGE — 56

64

INTERFEROMETERS

STAGE MOTOR(S) — 62